(19) Europäisches Patentamt

European Patent Office

Office européen des brevets

(11) **EP 2 583 177 B1**

(12) **FASCICULE DE BREVET EUROPEEN**

(45) Date de publication et mention de la délivrance du brevet:
**21.05.2014 Bulletin 2014/21**

(21) Numéro de dépôt: **11723065.6**

(22) Date de dépôt: **01.06.2011**

(51) Int Cl.:
*G06F 11/10* (2006.01)     *G11C 29/00* (2006.01)
*H03M 13/00* (2006.01)     *H03M 13/19* (2006.01)
*H03M 13/35* (2006.01)

(86) Numéro de dépôt international:
**PCT/EP2011/059134**

(87) Numéro de publication internationale:
**WO 2011/157568 (22.12.2011 Gazette 2011/51)**

(54) **PROCEDE DE PROTECTION DE MEMOIRE NUMERIQUE ET DISPOSITIF APPARENTE**

VERFAHREN UND VORRICHTUNG ZUR ABSICHERUNG EINES NUMERISCHEN SPEICHERS

METHOD AND APPARATUS FOR PROTECTING A NUMERIC MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.06.2010 FR 1054841**

(43) Date de publication de la demande:
**24.04.2013 Bulletin 2013/17**

(73) Titulaire: **Commissariat à l'Énergie Atomique et aux Énergies Alternatives 75015 Paris (FR)**

(72) Inventeurs:
• **EVAIN, Samuel**
  **F-91191 Gif-sur-Yvette (FR)**
• **BONHOMME, Yannick**
  **F-91530 LeVal-Saint-Germain (FR)**
• **GHERMAN, Valentin**
  **F-91300 Massy-Palaiseau (FR)**

(74) Mandataire: **Delaval, Guillaume Laurent Marks & Clerk France Immeuble Visium 22, avenue Aristide Briand 94117 Arcueil Cedex (FR)**

(56) Documents cités:
**US-A- 5 659 678         US-A1- 2005 149 833
US-A1- 2007 011 598     US-A1- 2007 103 998
US-A1- 2007 283 207**

**Description**

L'invention a pour objet un procédé de protection de mémoire numérique contre les erreurs permanentes et transitoires et un dispositif apparenté. Elle s'applique notamment aux domaines de l'électronique numérique et des technologies nanométriques. L'invention peut être utilisée, par exemple, dans des systèmes de mémorisation de données.

Dans un système numérique, les données ou informations sont habituellement enregistrées dans une mémoire numérique sous forme de valeurs binaires appelées bits. Des erreurs peuvent apparaître sur les données mémorisées et peuvent être transitoires ou permanentes, comme explicité ci-après. Si ces erreurs ne sont pas corrigées ou masquées, elles peuvent engendrer des erreurs de fonctionnement et finalement la défaillance du système.

Les erreurs transitoires sont produites par des interférences avec l'environnement ou par la radioactivité produite par certaines impuretés dans le matériau composant la mémoire numérique.

Pour ce qui est des erreurs permanentes, celles-ci résultent de défauts matériels et représentent un problème important en particulier dans les circuits de mémoire réalisés à base de technologie nanométrique. Les erreurs permanentes sont la conséquence de défauts de la structure physique des circuits, ces défauts apparaissant pendant la production des circuits et/ou à cause du vieillissement. Une densité élevée de défauts matériels dans un système de mémorisation se traduit par un nombre important d'erreurs permanentes. Ces problèmes doivent être pris en compte lors de la conception de systèmes numériques utilisant des circuits de mémoire.

Afin de garantir un niveau d'intégrité des données mémorisées acceptable ou pour augmenter le rendement de production, certains systèmes électroniques utilisent des codes correcteurs et détecteur d'erreurs, désignés habituellement par l'acronyme EDAC venant de l'expression anglo-saxonne « Error Detection And Correction ».

Dans des systèmes numériques mettant en oeuvre une protection de type EDAC, les données sont encodées lors de l'écriture desdites données dans la ou les zones de stockage comprises dans un ou plusieurs circuits de mémoire. Lors de l'encodage de données avec un code EDAC, des bits de vérification appelés aussi bits de redondance, sont ajoutés à des mots de données binaires de manière à former des mots de code. Les bits de vérification d'un code EDAC linéaire sont calculés à l'aide d'une matrice de parité H. Ces derniers sont choisis de manière à ce que la multiplication entre la matrice H et le mot de code formé par la concaténation des bits de données avec les bits de vérification produise un vecteur nul.

Lors de la lecture des données présentes dans le ou les circuits de mémoire, les mots de code sont vérifiés. Pour cela un vecteur de vérification appelé aussi syndrome est calculé afin de détecter et corriger des erreurs potentielles apparaissant dans les mots de code. Si le syndrome correspond à un vecteur nul, le mot codé est considéré comme correct. Un syndrome non-nul indique la présence d'au moins une erreur. Si le syndrome permet d'identifier les positions des bits affectés, le mot de code est corrigé, sinon une erreur incorrigible est signalée.

Différents codes EDAC peuvent être mis en oeuvre, ces derniers ayant des capacités de détection et de correction d'erreurs différentes. A titre d'exemple, le codage de Hamming permet de corriger une erreur simple, c'est-à-dire une erreur qui affecte un seul bit. Cette capacité de correction est qualifiée de SEC acronyme venant de l'expression anglo-saxonne « Single Error Correction ».

Un autre exemple de code EDAC est le code de Hamming étendu. Un code de Hamming étendu est un code de Hamming pour lequel un bit de parité est ajouté sur l'ensemble des bits d'un mot de code, ceci afin de permettre la détection d'erreurs doubles, c'est-à-dire d'erreurs affectant deux bits dans un mot de code. Les codes de cette famille sont capables de corriger une erreur simple et de détecter une erreur double. Cette capacité de correction est qualifiée de SEC-DED, acronyme venant de l'expression anglo-saxonne « Single Error Correction - Double Error Detection ». Un autre exemple de code ayant une capacité SEC-DED est le code de Hsiao.

Les codes SEC-DED permettent de traiter à la fois des erreurs permanentes et/ou transitoires. Mais, habituellement, lorsque ces solutions sont utilisées pour corriger des erreurs permanentes, elles perdent souvent leur capacité à corriger des erreurs transitoires.

Il existe des codes EDAC permettant la correction d'erreurs simples ainsi que la correction d'une sélection d'erreurs doubles et ce tout en ayant la capacité de détecter des erreurs doubles incorrigibles. Un exemple d'un tel code est décrit dans le brevet US 3755779 intitulé *Error correction system for single-error correction, related-double-error correction and unrelated-double-error-detection.* Dans ce brevet, les erreurs doubles pouvant être corrigées doivent être composées de deux bits adjacents. Ce type d'erreurs doubles correspond habituellement à des erreurs transitoires plutôt qu'à des erreurs permanentes. La correction d'erreurs doubles adjacentes ne permet pas de couvrir toutes les combinaisons d'erreurs possibles dans le cas où des erreurs permanentes interviennent.

Les codes permettant la correction de toutes les erreurs multiples qui affectent au moins deux bits dans un mot de code sont très coûteux en termes de calcul, de performance, de surface et de consommation. Il est donc difficile en pratique de mettre en oeuvre un tel code de manière systématique pour protéger l'ensemble d'une mémoire électronique.

Une autre technique consiste à utiliser des colonnes de secours, technique désignée par l'expression anglo-saxonne « column replacement ». En effet, un circuit de mémoire est composé d'au moins une zone de stockage appelée aussi banc mémoire, une zone de stockage correspondant habituellement à une matrice de mémorisation composée de cellules de mémoire organisées en un nombre donné de lignes et de colonnes. Un bit mémorisé est ainsi positionné dans une cellule de mémoire localisée à l'intersection d'une ligne et d'une colonne du banc. L'utilisation de colonnes supplémentaires appelées colonnes de secours permet de masquer des colonnes défectueuses, c'est-à-dire de les remplacer. Un inconvénient inhérent à cette technique est qu'elle ne permet pas de traiter les erreurs transitoires, seules des erreurs permanentes peuvent être traitées.

Des approches mixtes combinant l'utilisation des techniques à base de codes EDAC avec des techniques à base de colonnes de secours ont été proposées. Elles permettent de tolérer une grande densité d'erreurs permanentes, comme décrit notamment dans l'article de C. H. Stapper et Hsing-San Lee intitulé Synergistic Fault-Tolerance for Memory Chips, IEEE Trans. Computers 41 (9), 1992, pages 1078-1087, XP 329629.

Le document D1 = US-A1-2005/0149 833 divulgue l'utilisation d'une matrice de Hamming pour l'encodage de mots de code. Au moins deux quelconques des lignes ou colonnes de la matrice de Hamming peuvent être permutées afin de permettre à la matrice de remplir certaines règles à satisfaire. Ce document combine également l'utilisation de code de correction d'erreur avec l'utilisation de cellules mémoires redondantes.

L'utilisation simultanée des colonnes de secours et d'un code EDAC a un coût important en surface. Il est donc crucial de minimiser le nombre de colonnes de secours tout en maintenant une protection élevée contre les erreurs permanentes et transitoires.

Dans la plupart des bancs composant un circuit de mémoire, le remplacement des colonnes entièrement défectueuses ne nécessite pas l'utilisation de toutes les colonnes de secours. Dans ce cas, les colonnes de secours encore disponibles peuvent être utilisées pour remplacer des colonnes mémoire comportant des cellules de mémoire défectueuses.

Un but de l'invention est notamment de pallier les inconvénients précités.

L'invention a pour objet un procédé de protection de données numériques mémorisées dans au moins une zone de stockage, ladite zone correspondant à une matrice de mémorisation composée de cellules de mémoire organisées en un nombre donné de lignes et de colonnes. Ledit procédé comporte une étape d'encodage générant des mots de code à partir des données organisées en mots binaires par application d'un code asymétrique introduisant au moins deux niveaux de protection différents, le premier niveau de protection dit élevé étant associé à un premier sous-groupe de bits du mot de code et un second niveau de protection dit bas étant associé à un deuxième sous-groupe du même mot ; il comprend aussi une étape d'échange de positions des bits du mot de code faisant correspondre pour leur mémorisation les bits de niveau de protection élevé aux colonnes de la zone de stockage comportant des cellules de mémoire défectueuses et les bits de niveau de protection bas aux colonnes restantes.

Selon un aspect de l'invention, le nombre de bits d'un mot de code correspond au nombres de colonnes disponibles dans une zone de stockage.

Selon un autre aspect de l'invention, le code asymétrique est choisi de manière à introduire une protection sur les f derniers bits de chaque mot de code par utilisation d'un code de Hamming, le sous-groupe composé des autres bits dudit mot n'étant pas protégé.

Le code asymétrique est, par exemple, un code SEC-DED étendu avec s bits de vérification supplémentaires.

Dans un mode de réalisation, la matrice du code asymétrique est adaptée de manière à ce que ledit code permette la correction d'une erreur simple sur l'ensemble du mot de code, assure la correction d'une erreur double quelconque qui affecte au moins un bit d'un sous ensemble de f bits dans le mot de code, ce sous ensemble étant celui auquel est associé un niveau de protection élevé et permette la détection des autres erreurs doubles sur l'ensemble du mot du code.

L'invention a aussi pour objet un procédé de lecture de données numériques mémorisées dans une zone de stockage et protégées par mise en oeuvre du procédé de protection de données numériques décrit précédemment. Ce procédé de lecture comporte une étape de remise dans l'ordre des bits des mots de code mémorisés de manière à ce que ceux-ci retrouvent leur ordre initial d'avant l'échange de position réalisé lors de leur écriture en mémoire ; et une étape de décodage desdits mots de code réordonnancés, cette étape réalisant une détection d'erreurs dans le mot de code ainsi qu'une correction d'erreur, lesdites détection et correction dépendant du code asymétrique utilisé à l'encodage ainsi que de ses capacités de correction et de détection.

L'invention a aussi pour objet un dispositif de protection de données numériques mémorisées dans au moins une zone de stockage, ladite zone correspondant à une matrice de mémorisation composée de cellules de mémoire organisées en un nombre donné de lignes et de colonnes. Le dispositif comporte au moins

• un module d'encodage générant des mots de code à partir des données organisées en mots binaires par application d'un code asymétrique introduisant au moins deux niveaux de protection différents, le premier niveau de protection dit élevé étant associé à un premier sous-groupe de bits du mot de code et le second niveau de protection dit bas étant associé à un deuxième sous-groupe du même mot ;

- un module d'échange de position des bits du mot de code faisant correspondre pour leur mémorisation les bits de niveau de protection élevé desdits mots aux colonnes de la zone de stockage comportant des cellules de mémoire défectueuses et les bits de niveau de protection bas aux colonnes restantes.

Dans un mode de réalisation, l'échange de position des bits réalisés par le module d'échange est contrôlé en utilisant des données de configuration indiquant les colonnes mémoire comportant des cellules de mémoire défectueuses de la zone de stockage.

Selon un aspect de l'invention, le module d'échange comprend des multiplexeurs permettant de router les bits en sortie du module d'encodage vers les colonnes de la zone de stockage, lesdits multiplexeur étant contrôlés par des signaux de contrôle $M_j$ représentatifs des données de configuration.

Selon un autre aspect de l'invention, le dispositif comporte des moyens pour remettre dans l'ordre les bits des mots de code mémorisés de manière à ce que ceux-ci retrouvent leur ordre initial d'avant échange, et des moyens pour décoder le mots de code réordonnancés en réalisant une détection d'erreurs dans le mot de code ainsi qu'une correction d'erreurs, lesdites détection et correction dépendant du code asymétrique utilisé par le module d'encodage ainsi que de ses capacité de correction et de détection.

Si une erreur incorrigible est détectée, un signal d'erreur est par exemple généré.

L'invention a notamment comme avantage d'optimiser la capacité de correction des codes utilisées pour protéger les données mémorisées dans une mémoire numérique tout en limitant le nombre de colonnes de secours. Il est par ailleurs possible de reconfigurer le circuit de mémoire mettant en oeuvre l'invention en tenant compte de la distribution spécifique des cellules de mémoire défectueuses, cette reconfiguration pouvant être mise en oeuvre lors de la production du circuit de mémoire ou/et durant son exploitation.

D'autres caractéristiques et avantages de l'invention apparaîtront à l'aide de la description qui suit, donnée à titre illustratif et non limitatif et faite en regard des dessins annexés parmi lesquels :

- la figure 1 illustre le principe d'un dispositif de protection de mémoire selon l'invention ;
- la figure 2 donne un exemple de matrice de parité H permettant la mise en oeuvre d'un code asymétrique A-EDAC assurant la correction d'erreurs simples affectant un sous-ensemble de f bits dans les mots de code ;
- la figure 3 donne un exemple de structure de matrice de parité H permettant la mise en oeuvre d'un code asymétrique A-EDAC assurant la correction d'erreurs simples sur l'ensemble des mots de code, la correction d'erreurs doubles affectant un sous-ensemble de bits dans les mots de code et la détection d'erreurs doubles incorrigibles sur l'ensemble dudit mot ;
- la figure 4 présente un exemple spécifique de matrice de parité H selon la matrice H générique décrite à l'aide de la figure 3 ;
- la figure 5 présente un second exemple spécifique de matrice de parité H selon la matrice H générique décrite à l'aide de la figure 3 ;
- La figure 6 donne un exemple de module échangeur selon l'invention.

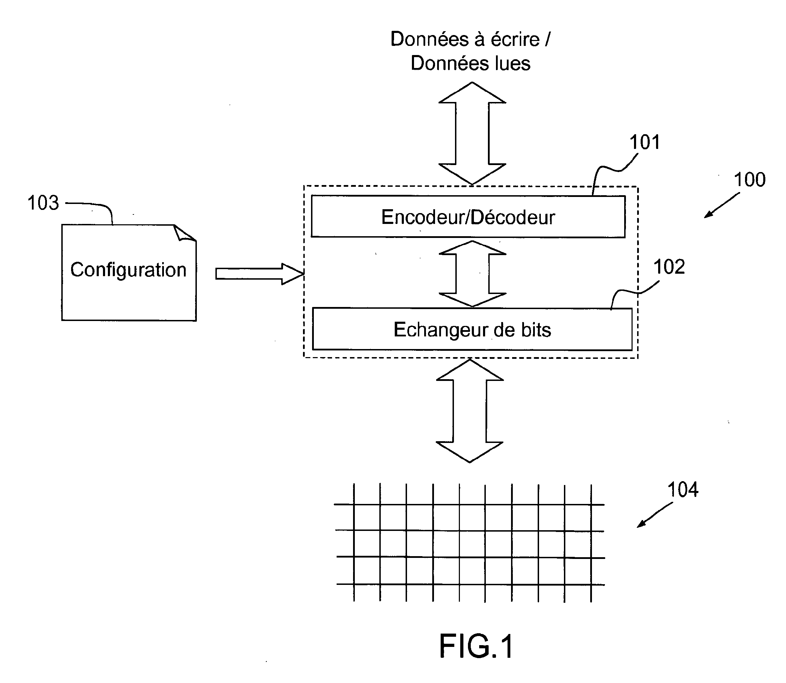

La figure 1 illustre le principe d'un dispositif de protection de mémoire selon l'invention. Le dispositif 100 contient par exemple deux modules réalisant des opérations distinctes mettant en oeuvre la protection selon l'invention, que ce soit pour des accès en lecture ou en écriture dans une mémoire.

Lors d'un accès en écriture, le premier module 101 réalise la fonction d'encodage des données présentées sous forme de mots en utilisant, par exemple, un code asymétrique. Dans la suite de la description, un code asymétrique désigne un code EDAC associant des niveaux de protections différents à plusieurs sous-groupes de bits composant les mots de code. Ce type de code est aussi désigné dans la description en utilisant l'acronyme A-EDAC.

Dans la suite de la description, les exemples choisis de codes asymétriques A-EDAC présentent deux niveaux de protection : un mot de code comprend un premier sous ensemble de bits associé à un niveau de protection élevé et un second sous-ensemble de bits associé à un niveau de protection bas.

Le choix du code A-EDAC dépend de l'application et du type de protection recherché.

A titre d'exemple, dans le cas où l'on désire protéger la mémoire numérique contre les erreurs permanentes uniquement, un code SEC restreint peut être choisi. Celui-ci est qualifié de restreint au sens où le niveaux de protection bas correspond à une absence de protection. Dans cet exemple, un mot de code peut être divisé en deux sous-ensembles de bits auxquels sont associés les deux niveaux de protection précédemment mentionnés. Le code SEC restreint assure une correction d'erreurs simples affectant le premier sous-ensemble de bits du mot de code, le deuxième groupe de bits n'étant pas protégé.

Un autre exemple correspond au cas où l'on veut protéger la mémoire à la fois contre des erreurs permanentes et contre des erreurs transitoires. Dans ce cas, un code A-EDAC adapté est par exemple un code SEC-DED étendu introduisant deux niveaux de protection associés à deux sous ensembles du mot de code. Comme déjà explicité, le premier niveau de protection est dit élevé et le second niveau de protection est dit bas. Ce code est adapté de manière à permettre pour un mot de code donné :

- la correction d'une erreur simple sur l'ensemble du mot de code ;
- la correction d'une erreur double affectant le sous-ensemble de bits de niveau de protection élevé ;
- la détection de toute erreur double sur l'ensemble du mot de code qui n'affecte aucun bit du sous-ensemble de bits de niveau de protection élevé.

La cardinalité du sous-ensemble de bits du mot de code dont le niveau de protection est élevé dépend du nombre s de colonnes de secours dans la zone de stockage.

Un deuxième module 102 a pour fonction d'établir une connexion entre les bits des données encodées produits par le module 101 réalisant l'encodage et les colonnes mémoires constituant la zone de stockage 104. Ce module fait correspondre les bits les mieux protégés des mots de code aux colonnes de la zone de stockage possédant des cellules mémoire défectueuses. Ces bits sont ainsi routés vers lesdites colonnes pendant l'opération d'écriture. Cette correspondance est assurée par le deuxième module 102 appelé échangeur de bits ou Bit-Swapper en anglais. Ce module 102 utilise notamment comme données d'entrée des informations de configuration 103 provenant de tests de la zone de stockage 104. Ces tests sont réalisés préalablement à l'utilisation de la mémoire, ou bien pendant des opérations de maintenance du circuit et indiquent pour chaque zone de stockage utilisée quelles sont les colonnes comportant des cellules de mémoire défectueuses.

Dans le cas de l'utilisation du dispositif pendant un accès en lecture, les bits de chaque colonne mémoire transitent par l'échangeur de bits 102 pour retrouver leur position originelle dans le mot de code A-EDAC. Le mot de code est ensuite vérifié par le module 101 réalisant le décodage du code A-EDAC. Ledit module réalise les opérations de détection et de correction d'erreurs et permet d'obtenir en sortie le mot de données corrigé ou bien un signal d'erreur indiquant la présence d'une erreur incorrigible.

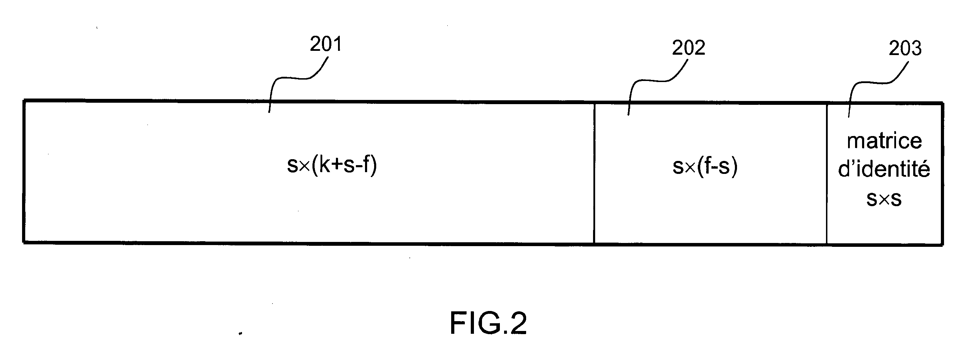

La figure 2 donne un exemple de matrice de parité H permettant la mise en oeuvre d'un code asymétrique A-EDAC assurant la correction d'erreurs simples affectant un sous-ensemble de f bits dans les mots de code.

Pour cela, la matrice H est agencée de manière à introduire deux niveaux de protection dans un mot de code. Aux deux niveaux de protection sont associés deux sous-ensembles de bits composant un mot de code. Le premier sous-ensemble de bits est composé de $f=2^s-1$ bits d'un mot de code et est protégé de manière à permettre la correction d'une erreur simple. s désigne le nombre de bits de vérification, celui-ci correspondant au nombre de colonnes de secours disponibles dans la zone de stockage. Le nombre de lignes dans la matrice H est égal à s. Le nombre de colonnes dans la matrice H est égal au nombre de colonnes mémoire dites régulières k où sont stockés les bits de données auquel s'ajoute le nombre s de colonnes de secours avec f<k+s. Tous les éléments de la matrice H appartiennent à l'ensemble {0,1}. La matrice H est constituée de trois sous-matrices. La première sous-matrice 201 possède k+s-f colonnes et tous ses éléments sont égaux à 0. La deuxième sous-matrice 202 possède f-s colonnes, lesdites colonnes étant définies en ce qu'elles :

- comprennent au moins un élément non-nul ;
- sont différentes des colonnes de la troisième matrice 203 décrite ci-après ;
- sont différentes entre elles.

La troisième sous-matrice 203 est une matrice identité sxs, c'est-à-dire comportant s lignes et s colonnes. Les sous-matrices 202 et 203 forment une matrice de Hamming s×f, c'est-à-dire avec s lignes et f colonnes et où toutes les colonnes sont différentes les unes par rapport aux autres et différentes du vecteur nul.

La matrice de parité H de la figure 2 permet de mettre en oeuvre un codage introduisant une protection du sous-ensemble de bits composé par les f derniers bits de chaque mot de code, un mot de code comportant k>f-s bits de données et s bits de vérification. Parmi ces f bits, il y a f-s bits de données et s bits de vérification. L'encodage et la vérification de ces f-s bits de données sont identiques à un code Hamming avec s bits de vérification et f-s bits de donnée. Les f bits correspondent au sous ensemble de bits auquel est associé le niveau de protection élevé.

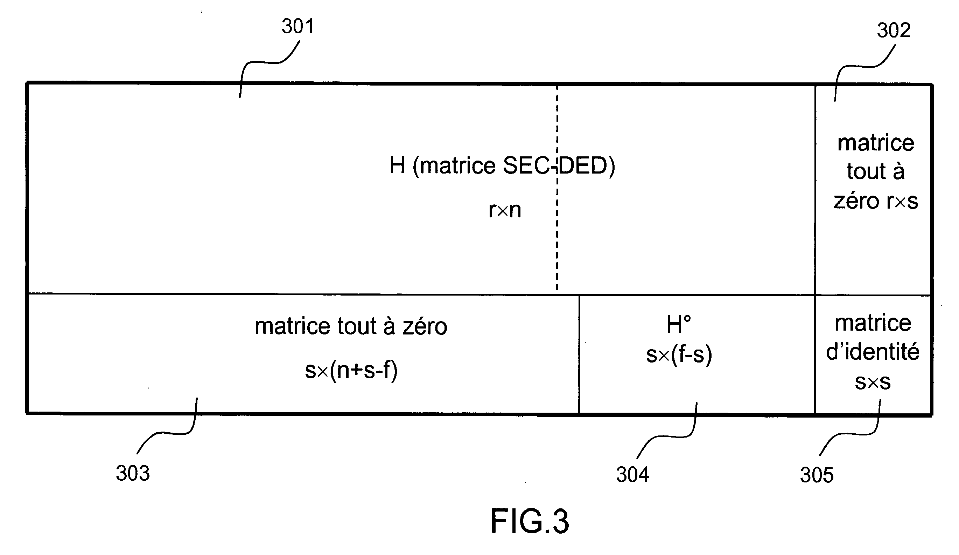

La figure 3 donne un exemple de structure générique de matrice de parité H permettant la mise en oeuvre d'un code asymétrique A-EDAC obtenu par l'extension d'un code SEC-DED avec s bits de vérification supplémentaires dans le but :

- de permettre la correction d'une erreur simple sur l'ensemble du mot de code ;
- d'assurer la correction d'une erreur double quelconque qui affecte au moins un bit d'un sous ensemble de f bits dans le mot de code, ce sous ensemble étant celui auquel est associé un niveau de protection élevé ;
- de permettre la détection de toute erreur double qui ne satisfait pas la condition précédente.

La matrice H est obtenue par extension à partir d'une première sous-matrice 301 représentant la matrice de parité d'un code SEC-DED standard avec k bits de données et r bits de vérification. La sous-matrice 301 possède r lignes et n=k+r colonnes. Les dernières r colonnes dans la sous-matrice 301 correspondent aux bits de vérification. Comme le code A-EDAC comprend s bits de vérification supplémentaires par rapport au code SEC-DED de la sous-matrice 301, la matrice H doit avoir s colonnes et s lignes supplémentaires par rapport à la sous-matrice 301.

L'extension de la sous-matrice 301 est réalisée à l'aide de quatre autres sous-matrices :

- une sous-matrice 302 comprenant r lignes et s colonnes située à droite de la sous-matrice 301 ;
- une sous-matrice 303 avec s lignes et n+s-f colonnes située en-dessous de la sous-matrice 301 ;
- une sous-matrice 304 comprenant s lignes et f-s colonnes et située en-dessous de la sous-matrice 301 et à droite de la sous-matrice 303 ;
- une sous-matrice 305 comprenant s lignes et s colonnes et située en-dessous de la sous-matrice 302 et à droite de la sous-matrice 304.

Les sous-matrices 302 et 303 sont des matrices nulles, c'est à dire qu'elles ont tous leurs éléments positionnés à zéro.

La sous-matrice 305 est une matrice d'identité sxs.

La sous-matrice 304 doit avoir toutes ses colonnes différentes entre elles et comporter au moins un élément non nul. Il en résulte un nombre maximal de $2^s$-1 colonnes pour la sous-matrice 304. Le paramètre f est alors égal à $2^s$-1+s.

Afin de permettre la réalisation de décodeurs A-EDAC rapides, la somme f des colonnes des sous-matrices 304 et 305 peut être choisie telle qu'elle soit inférieure ou égale à r+s. Le paramètre f est donc le plus petit des deux nombres r+s et $2^s$-1+s. Ainsi, le nombre de colonnes dans la sous-matrice 304 est limité par le nombre r des bits de vérification du code SEC-DED représenté par la matrice 301.

Les colonnes des sous-matrices 304 et 305 correspondent à un sous-ensemble de f bits de vérification du code A-EDAC. Comme indiqué précédemment, toutes les erreurs doubles qui affectent ces f bits de vérification doivent pouvoir être corrigées. Pour permettre d'atteindre cet objectif, le choix de la sous-matrice 304 impose une contrainte sur la sous-matrice 301. Afin d'expliquer cette contrainte, on définit d'abord la combinaison d'un certain nombre de colonnes dans une (sous-)matrice comme un vecteur dont chaque bit :

- correspond à une ligne dans la (sous-)matrice considérée e ;
- est le résultat d'un OU exclusif entre les bits correspondant à la même ligne dans les colonnes combinées.

Xs désigne l'ensemble des triplets de colonnes dans la sous-matrice 304 dont la combinaison donne un vecteur avec tous les bits positionnés à zéro. Les colonnes de chaque triplet de Xs étendues sur toute la matrice H définissent autant de triplets dans la sous-matrice 301. Si on désigne par Xr l'ensemble formé par ces derniers triplets, la contrainte sur la sous-matrice 301 interdit la présence dans cette sous-matrice d'une colonne identique à la combinaison des colonnes dans chaque triplet de l'ensemble Xr. De par la contrainte f<r+s, toutes les colonnes dans les triplets du Xr correspondent aux bits de vérification du code SEC-DED représenté par la sous-matrice 301.

La manière de générer les r+s bits de vérification pour cet exemple de code A-EDAC est décrite par la matrice H et peut être implémentée comme pour n'importe quel code linéaire. Plus précisément, de par la forme de la matrice H, les premiers r bits de vérification sont identiques aux bits de vérification du code SEC-DED avec la matrice de parité identique à la sous-matrice 301. A leur tour, ces bits de vérification peuvent être utilisés pour le calcul des autres s bits de vérification à l'aides des sous-matrices 304 et 305.

Lors du décodage des mots du code, r+s bits de syndrome Sj avec 0≤j<r+s sont calculés comme dans le cas d'un code linéaire quelconque. La correction des erreurs qui affectent les bits de données V'i (0≤i<k) récupérés dans la zone de stockage est réalisée en utilisant, par exemple, l'expression suivante :

$$V_i = V'_i \oplus BitFlip_i \quad 0 \le i < k \qquad\qquad (1)$$

dans laquelle :

- k est le nombre de bits de donnée ;
- i est l'indice d'un bit de donnée avec $0 \le i < k$ ;
- le symbole '$\oplus$' représente l'opération logique OU exclusif;
- $V_i$ représente le $i^{ème}$ bit de donnée corrigé ;
- $BitFlip_i$ est un signal calculé en utilisant l'expression suivante :

$$BitFlip_i = \bigwedge_{j=0}^{r+s-1}\left(H_j{}^i \,\overline{\oplus}\, S_j\right) \vee \bigvee_{l=n+s-f}^{n+s-1}\left[\bigwedge_{j=0}^{r+s-1}\left(H_j{}^i \oplus H_j{}^l\right)\overline{\oplus}S_j\right]; 0 \le i < k \quad (2)$$

dans laquelle :

- r est le nombre de bits de vérification du code SEC-DED représenté par la sous-matrice 301 ;
- n est le nombre total de bits dans le code SEC-DED, représenté par la sous-matrice 301 ;
- s est le nombre de bits de vérification supplémentaires dans le code A-EDAC ;
- f est le nombre des derniers bits de vérification du code A-EDAC pour lesquels on assure la correction de toutes les erreurs doubles dans lesquelles ces bits sont impliqués ;
- le symbole '$\overline{\oplus}$' représente l'opération logique OU exclusif inversé ;
- le symbole '$\wedge$' représente l'opération logique ET;
- le symbole '$\vee$' représente l'opération logique OU et
- $H_j{}^i$ représente l'élément situé sur la $j^{ème}$ ligne et la $i^{éme}$ colonne dans la matrice de parité H.

La forme choisie pour la matrice de parité H du code A-EDAC permet une détection rapide des erreurs doubles incorrigibles à l'aide de l'expression suivante où tous les symboles et notations ont été définis auparavant :

$$\bigvee_{j=0}^{r-1} S_j \wedge \overline{\bigoplus_{i=0}^{n-1} V'_i} \wedge \overline{\bigvee_{j=r}^{r+s-1} S_j} \quad (3)$$

Par la suite, la sous-matrice 304 des codes A-EDAC obtenus par l'extension des codes SEC-DED sera notée avec le symbole H°.

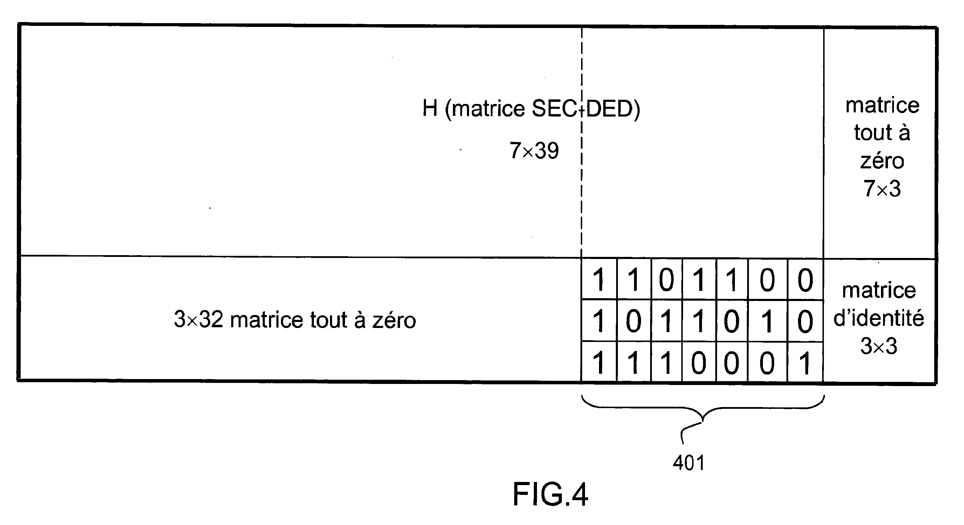

La figure 4 présente un exemple spécifique de matrice de parité H selon la matrice H générique décrite à l'aide de la figure 3. C'est une matrice de parité H d'un code A-EDAC qui est obtenue par l'extension avec 3 bits de vérification supplémentaires ajoutés à un code SEC-DED avec 32 bits de données. Elle comprend une sous-matrice H° 401 de 3 lignes et $2^3-1 = 7$ colonnes. Le nombre de colonnes dans la matrice H° est égal au nombre des bits de vérification du code SEC-DED. Les mots du code SEC-DED comprennent 32 bits de données et 7 bits de vérification. Le code A-EDAC qui en résulte permet de corriger une erreur double quelconque affectant les f=10 bits de vérification d'un mot du code. Dans ce cas, le paramètre f est égal au nombre total de bits de vérification dans le code r+s mais aussi à l'expression $2^s-1+s$.

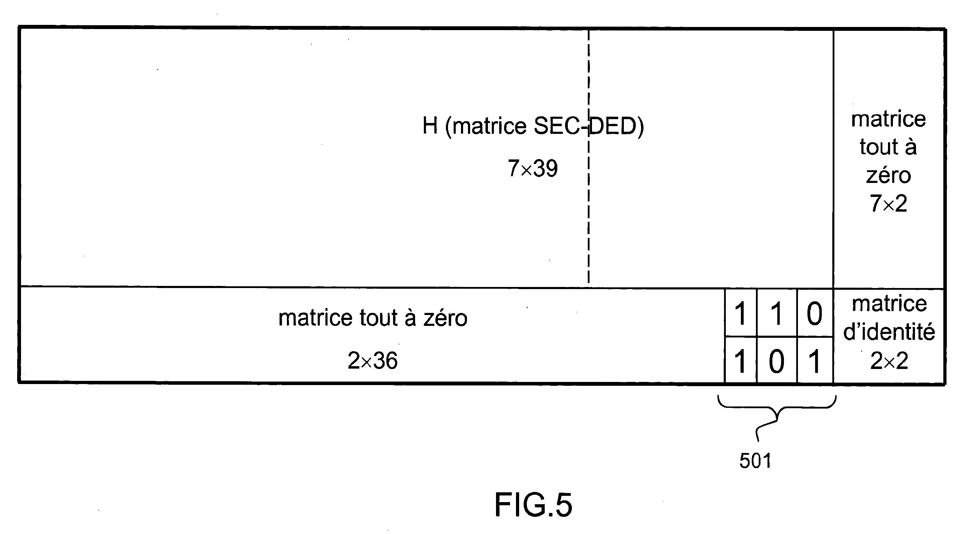

La figure 5 présente un exemple spécifique de matrice de parité H selon la matrice H générique décrite à l'aide de la figure 3.

Cette exemple permet d'obtenir un code A-EDAC correspondant à l'extension d'un code SEC-DED avec 2 bits de vérification supplémentaires. Les mots de code SEC-DED ont 32 bits de donnée et 7 bits de vérification. La sous-matrice H° 501 comprend $2^2-1 = 3$ colonnes. Le code résultant de cette matrice permet la correction de toutes les erreurs doubles qui affectent les derniers $f = 2^2-1+2 = 5$ bits de vérification dans les mots de code.

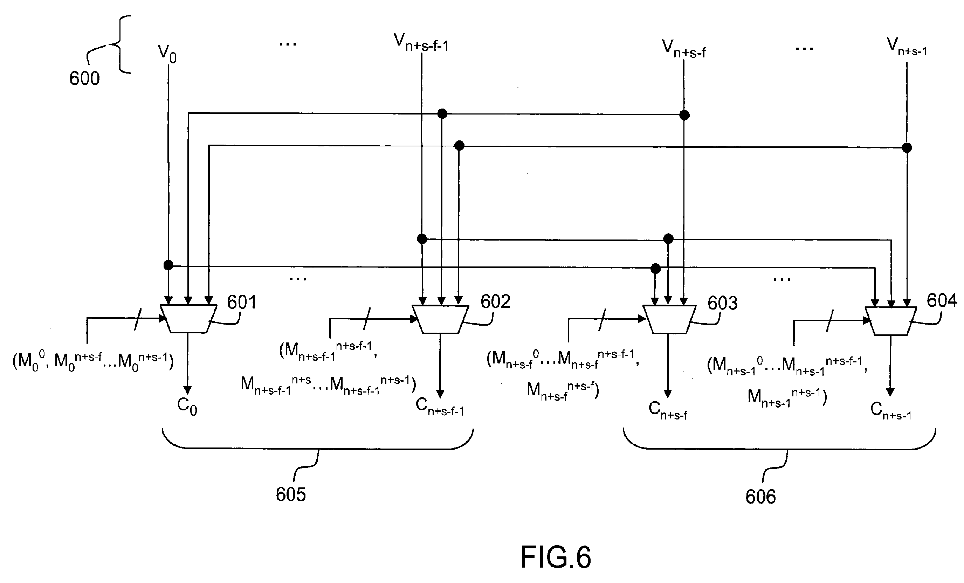

La figure 6 donne un exemple de module échangeur. Le dispositif établit une connexion entre les bits des mots de code générés par un code asymétrique et les colonnes de la zone de stockage en tenant compte de la présence des cellules de stockage défectueuses dans les colonnes de ladite zone.

Une connexion est établie entre chaque bit $V_j$ d'un mot de code 600 et chaque colonne mémoire $C_i$. Les indices i et j sont tels que $0 \le j < n+s$ et $0 \le i < n+s$.

La mise en oeuvre de ces connexions est établie à l'aide de multiplexeurs 601, 602, 603, 604 contrôlés par des signaux de contrôle $M_i{}^j$. La sortie d'un multiplexeur donné est connectée à une colonne donnée de la zone de stockage.

Les premières n+s-f multiplexeurs 605 reçoivent en entrée les derniers f bits $V_j$ (n+s-f≤j<n+s) d'un mot du code, c'est-à-dire les bits auxquels est associé un niveau de protection élevé. Ainsi, l'une de ces f entrées est routée vers la colonne de la zone de stockage associée au multiplexeur si ladite colonne contient des cellules de stockage défectueuses.

La connexion entre les positions dans les mots du code A-EDAC et les colonnes mémoire peut être faite par interchangement. A titre d'exemple, si le $j^{ème}$ bit du mot de code est connecté à la $i^{ème}$ colonne de la zone de stockage, alors le $i^{ème}$ bit du mot de code est connecté à la $j^{ème}$ colonne de la zone de stockage. Afin de permettre ces interchangements, les derniers f multiplexeurs reçoivent en entrée les premiers n+s-f bits des mots de code. Si les premières n+s-f colonnes de la zone de stockage ont toutes leurs cellules de stockage opérationnelles, c'est-à-dire non défectueuse, alors les multiplexeurs correspondant seront configurés de manière à sélectionner en entrée le bit dans les mots de code ayant le même index que la colonne connectée à la sortie dudit multiplexer.

Les signaux de contrôle $M_i^j$ peuvent être générés en fonction de bits $T_i$ avec $0 \leq i < n+s-f$, indiquant si les premières n+s-f colonnes mémoire ont des cellules de stockage défectueuses, ainsi que de $T'_j$ bits indiquant si la j$^{\text{ème}}$ colonne de la zone de stockage avec $n+s-f \leq j < n+s$ est utilisée pour stocker des bits d'index j dans les mots du code. Les signaux $M_i^j$, avec $0 \leq i < n+s-f$, contrôlant les premiers n+s-f multiplexeurs 605 sont générés à partir des bits $T_i$, et $T'_j$. Pour cela, les expressions suivantes dont tous les symboles et notations ont été définis précédemment peuvent être utilisées :

$$M_i^i = \overline{T_i}; \qquad (4)$$

$$M_i^j = T_i \wedge \overline{T'_j} \wedge \left( \overline{\bigvee_{t=n+s-f}^{j-1} M_i^t} \right) \wedge \left( \overline{\bigvee_{s=0}^{i-1} M_s^j} \right); \qquad (5)$$

$$0 \leq i < n+s-f; \quad n+s-f \leq j < n+s \qquad (6)$$

Les signaux de contrôle $M_i^j$ des derniers f multiplexeurs 606, avec $n+s-f \leq i < n+s$ et $0 \leq j < n+s-f$, peuvent être générés en utilisant les expressions suivantes :

$$M_i^i = T'_i; \qquad (7)$$

$$M_i^j = M_j^i; \qquad (8)$$

$$n+s-f \leq i < n+s; \quad 0 \leq j < n+s-f \qquad (9)$$

Un circuit de mémoire peut être segmenté en plusieurs zones de stockages, appelées aussi bancs mémoire ou segments. L'invention peut être avantageusement appliquée aux bancs mémoire qui ne contiennent pas plus d'une cellule de stockage défectueuse dans un même mot de code. Des méthodes conventionnelles, comme par exemple le masquage de colonnes, peuvent être utilisées pour les segments ou bancs mémoire qui ont au moins deux cellules de stockage défectueuses dans le même mot de code. Cette situation apparaît habituellement dans des bancs ou segments mémoire qui ont des colonnes entièrement endommagées.

Les matrices représentées ne sont que des exemples. Il est possible de faire des permutations des colonnes des matrices.

On peut réaliser un SEC étendu sans qu'il soit DED. La sous-matrice 301 représente alors un code SEC et non SEC-DED.

## Revendications

1. Procédé de protection de données numériques mémorisées dans au moins une zone de stockage (104), ladite zone correspondant à une matrice de mémorisation composée de cellules de mémoire organisées en un nombre donné de lignes et de colonnes, ledit procédé étant **caractérisé en ce qu'**il comporte :

   - une étape d'encodage (101) générant des mots de code à partir des données organisées en mots binaires par application d'un code asymétrique introduisant au moins deux niveaux de protection différents, le premier niveau de protection dit élevé étant associé à un premier sous-groupe de bits du mot de code et un second niveau de protection dit bas étant associé à un deuxième sous-groupe du même mot ;
- une étape d'échange de positions des bits du mot de code (102) faisant correspondre pour leur mémorisation les bits de niveau de protection élevé aux colonnes de la zone de stockage comportant des cellules de mémoire défectueuses et les bits de niveau de protection bas aux colonnes restantes.

**2.** Procédé selon la revendication 1 **caractérisé en ce que** le nombre de bits d'un mot de code correspond au nombres de colonnes disponibles dans une zone de stockage.

**3.** Procédé selon l'une quelconque des revendications précédentes **caractérisé en ce que** le code asymétrique est choisi de manière à introduire une protection sur les f derniers bits de chaque mot de code par utilisation d'un code de Hamming, le sous-groupe composé des autres bits dudit mot n'étant pas protégé.

**4.** Procédé selon l'une quelconque des revendications 1 ou 2 **caractérisé en ce que** le code asymétrique est un code SEC-DED étendu avec s bits de vérification supplémentaires.

**5.** Procédé selon la revendication 4 **caractérisé en ce que** la matrice du code asymétrique est adaptée de manière à ce que ledit code permette la correction d'une erreur simple sur l'ensemble du mot de code, assure la correction d'une erreur double quelconque qui affecte au moins un bit d'un sous ensemble de f bits dans le mot de code, ce sous ensemble étant celui auquel est associé un niveau de protection élevé et permette la détection des autres erreurs doubles sur l'ensemble du mot du code.

**6.** Procédé de lecture de données numériques mémorisées dans une zone de stockage et protégées par mise en oeuvre du procédé selon l'une quelconque des revendications 1 à 5 **caractérisé en ce qu'**il comporte :

- une étape de remise dans l'ordre (102) des bits des mots de code mémorisés de manière à ce que ceux-ci retrouvent leur ordre initial d'avant l'échange de position réalisé lors de leur écriture en mémoire ;
- une étape de décodage (101) desdits mots de code réordonnancés, cette étape réalisant une détection d'erreurs dans le mot de code ainsi qu'une correction d'erreur, lesdites détection et correction dépendant du code asymétrique utilisé à l'encodage ainsi que de ses capacités de correction et de détection.

**7.** Dispositif de protection de données numériques (100) mémorisées dans au moins une zone de stockage (104), ladite zone correspondant à une matrice de mémorisation composée de cellules de mémoire organisées en un nombre donné de lignes et de colonnes, ledit dispositif étant **caractérisé en ce qu'**il comporte au moins :

- un module d'encodage (101) générant des mots de code à partir des données organisées en mots binaires par application d'un code asymétrique introduisant au moins deux niveaux de protection différents, le premier niveau de protection dit élevé étant associé à un premier sous-groupe de bits du mot de code et le second niveau de protection dit bas étant associé à un deuxième sous-groupe du même mot ;
- un module d'échange de position des bits du mot de code (102) faisant correspondre pour leur mémorisation les bits de niveau de protection élevé desdits mots aux colonnes de la zone de stockage comportant des cellules de mémoire défectueuses et les bits de niveau de protection bas aux colonnes restantes.

**8.** Dispositif selon la revendication 7 **caractérisé en ce que** l'échange de position des bits réalisés par le module d'échange (102) est contrôlé en utilisant des données de configuration (103) indiquant les colonnes mémoire comportant des cellules de mémoire défectueuses de la zone de stockage (104).

**9.** Dispositif selon l'une quelconque des revendications 7 ou 8 **caractérisé en ce que** le module d'échange (102) comprend des multiplexeurs (601, 602, 603, 604) permettant de router les bits en sortie du module d'encodage vers les colonnes de la zone de stockage, lesdits multiplexer étant contrôlés par des signaux de contrôle $M_i^j$ représentatifs des données de configuration (103).

**10.** Dispositif selon la revendication 8 **caractérisé en ce qu'**il comporte des moyens pour remettre dans l'ordre les bits des mots de code mémorisés de manière à ce que ceux-ci retrouvent leur ordre initial d'avant échange, et des moyens pour décoder le mots de code réordonnancés en réalisant une détection d'erreurs dans le mot de code ainsi qu'une correction d'erreurs, lesdites détection et correction dépendant du code asymétrique utilisé par le module d'encodage ainsi que de ses capacité de correction et de détection.

**11.** Dispositif selon la revendication 10 **caractérisé en ce qu'**une erreur incorrigible est détectée, un signal d'erreur est généré.

**Patentansprüche**

**1.** Verfahren zum Absichern von digitalen Daten, die in wenigstens einer Speicherzone (104) gespeichert sind, wobei die Zone einer Speichermatrix bestehend aus Speicherzellen entspricht, die in einer gegebenen Anzahl von Reihen und Spalten organisiert sind, wobei das Verfahren **dadurch gekennzeichnet ist, dass** es Folgendes beinhaltet:

- einen Codierschritt (101) zum Erzeugen von Codewörtern von Daten, die in binären Wörtern organisiert sind, durch Anwenden eines asymmetrischen Codes, der wenigstens zwei unterschiedliche Absicherungsstufen einführt, wobei die als hoch bezeichnete erste Absicherungsstufe mit einer ersten Untergruppe von Bits des Codeworts assoziiert ist und wobei eine als niedrig bezeichnete zweite Absicherungsstufe mit einer zweiten Untergruppe desselben Worts assoziiert ist;
- einen Schritt des Austauschens von Positionen der Bits des Codeworts (102), um zu bewirken, dass die Bits der hohen Absicherungsstufe für ihre Speicherung den Spalten der Speicherzone, die mangelhafte Speicherzellen enthalten, und die Bits der niedrigen Absicherungsstufe den übrigen Spalten entsprechen.

**2.** Verfahren nach Anspruch 1, **dadurch gekennzeichnet, dass** die Anzahl von Bits eines Codewortes der Anzahl von in einer Speicherzone verfügbaren Spalten entspricht.

**3.** Verfahren nach einem der vorherigen Ansprüche, **dadurch gekennzeichnet, dass** der asymmetrische Code so ausgewählt wird, dass Absicherung auf den f letzten Bits jedes Codeworts mittels eines Hamming-Codes eingeführt wird, wobei die aus den anderen Bits des Wortes zusammengesetzte Untergruppe nicht abgesichert wird.

**4.** Verfahren nach Anspruch 1 oder 2, **dadurch gekennzeichnet, dass** der asymmetrische Code ein erweiterter SEC-DED-Code mit s zusätzlichen Verifizierungsbits ist.

**5.** Verfahren nach Anspruch 4, **dadurch gekennzeichnet, dass** die Matrix des asymmetrischen Codes so ausgelegt ist, dass der Code die Korrektur eines einfachen Fehlers des gesamten Codeworts zulässt, die Korrektur eines Doppelfehlers gewährleistet, der wenigstens ein Bit einer Teilmenge von f Bits in dem Codewort beeinflusst, wobei die Teilmenge die ist, die mit einer hohen Absicherungsstufe assoziiert ist, und die Erkennung der anderen Doppelfehler am gesamten Codewort zulässt.

**6.** Verfahren zum Lesen von digitalen Daten, die in einer Speicherzone gespeichert sind und durch Implementieren des Verfahrens nach einem der Ansprüche 1 bis 5 abgesichert werden, **dadurch gekennzeichnet, dass** es Folgendes beinhaltet:

- einen Schritt (102) des Umordnens der Bits der gespeicherten Codewörter zurück in ihre ursprüngliche Reihenfolge vor dem Austausch von Positionen, der erfolgte, als sie in den Speicher geschrieben wurden;
- einen Schritt (101) des Decodierens der umgeordneten Codewörter, wobei dieser Schritt das Erkennen von Fehlern in dem Codewort sowie eine Fehlerkorrektur beinhaltet, wobei Erkennung und Korrektur von dem beim Codieren verwendeten asymmetrischen Code sowie von seinen Korrektur- und Erkennungsfähigkeiten abhängig sind.

**7.** Vorrichtung zum Absichern von digitalen Daten (100), die in wenigstens einer Speicherzone (104) gespeichert sind, wobei die Zone einer Speichermatrix entspricht, die aus Speicherzellen zusammengesetzt ist, die in einer gegebenen Anzahl von Reihen und Spalten organisiert sind, wobei die Vorrichtung **dadurch gekennzeichnet ist, dass** sie wenigstens Folgendes umfasst:

- ein Codiermodul (101), das Codewörter von zu binären Wörtern organisierten Daten durch Anwenden eines asymmetrischen Codes erzeugt, der wenigstens zwei verschiedene Absicherungsstufen einführt, wobei die als hoch bezeichnete erste Absicherungsstufe mit einer ersten Untergruppe von Bits des Codeworts assoziiert ist und die als niedrig bezeichnete zweite Absicherungsstufe mit einer zweiten Untergruppe desselben Wortes assoziiert ist;
- ein Modul zum Austauschen der Position der Bits des Codewortes (102), um zu bewirken, dass die Bits der hohen Absicherungsstufe der Wörter für ihre Speicherung den Spalten der Speicherzone, die fehlerhafte Speicherzellen enthalten, und die Bits der niedrigen Absicherungsstufe den übrigen Spalten entsprechen.

8. Vorrichtung nach Anspruch 7, **dadurch gekennzeichnet, dass** der von dem Austauschmodul (102) durchgeführte Austausch der Bitpositionen mittels Konfigurationsdaten (103) gesteuert wird, die die Speicherspalten anzeigen, die fehlerhafte Speicherzellen der Speicherzone (104) umfassen.

9. Vorrichtung nach einem der Ansprüche 7 oder 8, **dadurch gekennzeichnet, dass** das Austauschmodul (102) Multiplexer (601, 602, 603, 604) umfasst, die das Leiten der Bits am Ausgang des Codierungsmoduls zu den Spalten der Speicherzone zulässt, wobei die Multiplexer von Steuersignalen $M_i^j$ gesteuert werden, die Konfigurationsdaten (103) repräsentieren.

10. Vorrichtung nach Anspruch 8, **dadurch gekennzeichnet, dass** sie Mittel zum Umordnen der Bits der gespeicherten Codewörter zurück in ihre ursprüngliche Reihenfolge vor dem Austausch und Mittel zum Decodieren der umgeordneten Codewörter durch Fehlererkennung in dem Codewort sowie durch Fehlerkorrektur umfasst, wobei Erkennung und Korrektur von dem vom Codiermodul benutzten asymmetrischen Code sowie von seinen Korrektur- und Erkennungsfähigkeiten abhängig sind.

11. Vorrichtung nach Anspruch 10, **dadurch gekennzeichnet, dass**, wenn ein unkorrigierbarer Fehler erkannt wird, ein Fehlersignal erzeugt wird.

**Claims**

1. A method for protecting digital data stored in at least one storage zone (104), said zone corresponding to a storage matrix composed of memory cells organised into a given number of rows and columns, said method being **characterised in that** it comprises:

   - an encoding step (101) generating code words from data organised into binary words by applying an asymmetric code introducing at least two different levels of protection, the first protection level, referred to as high, being associated with a first sub-group of bits of the code word, and a second protection level, referred to as low, being associated with a second sub-group of the same word;
   - a step of exchanging positions of the bits of the code word (102) so as to match, for their storage, the high protection level bits with the columns of the storage zone comprising defective memory cells and the low protection level bits with the remaining columns.

2. The method according to claim 1, **characterised in that** the number of bits of a code word corresponds to the number of columns available in a storage zone.

3. The method according to any one of the preceding claims, **characterised in that** the asymmetric code is selected so as to introduce protection on the f last bits of each code word by using a Hamming code, with the sub-group composed of the other bits of said word not being protected.

4. The method according to claim 1 or 2, **characterised in that** the asymmetric code is an extended SEC-DED code with s additional verification bits.

5. The method according to claim 4, **characterised in that** the matrix of the asymmetric code is designed so that said code allows the correction of a single error on the whole of the code word, ensures the correction of any double error that affects at least one bit of a sub-set of f bits in the code word, with said sub-set being that which is associated with a high protection level, and allows the detection of the other double errors on the whole of the code word.

6. A method for reading digital data stored in a storage zone and protected by implementing the method according to any one of claims 1 to 5, **characterised in that** it comprises:

   - a step (102) of reordering the bits of the stored code words so that they return to their initial order before the exchange of position carried out when they were written into memory;
   - a step (101) of decoding said reordered code words, said step involving the detection of errors in the code word, as well as an error correction, said detection and correction depending on the asymmetric code used during encoding as well as its correction and detection capabilities.

7. A device for protecting digital data (100) stored in at least one storage zone (104), said zone corresponding to a storage matrix composed of memory cells organised into a given number of lines and columns, said device being **characterised in that** it comprises at least:

   - an encoding module (101) generating code words from data organised into binary words by applying an asymmetric code introducing at least two different protection levels, the first protection level, referred to as high, being associated with a first sub-group of bits of the code word and the second protection level, referred to as low, being associated with a second sub-group of the same word;
   - a module for exchanging the position of the bits of the code word (102) so as to match, for their storage, the high protection level bits of said words with the columns of the storage zone comprising defective memory cells and the low protection level bits with the remaining columns.

8. The device according to claim 7, **characterised in that** the exchange of the position of the bits carried out by the exchange module (102) is controlled using configuration data (103) indicating the memory columns comprising defective memory cells of the storage zone (104).

9. The device according to any of claims 7 or 8, **characterised in that** said exchange module (102) comprises multiplexers (601, 602, 603, 604) allowing the routing of the bits output from the encoding module toward the columns of the storage zone, said multiplexers being controlled by control signals $M_i^j$ representing configuration data (103).

10. The device according to claim 8, **characterised in that** it comprises means for reordering the bits of the stored code words so that said code words return to their initial pre-exchange order, and means for decoding the reordered code words by detecting errors in the code word as well as correcting errors, said detection and correction depending on the asymmetric code used by the encoding module as well as its correction and detection capabilities.

11. The device according to claim 10, **characterised in that** when an incorrigible error is detected an error signal is generated.

Données à écrire /
Données lues

Configuration

103

101

100

Encodeur/Décodeur

102

Echangeur de bits

104

FIG.1

EP 2 583 177 B1

201

202

203

| $s \times (k+s-f)$ | $s \times (f-s)$ | matrice d'identité $s \times s$ |

## FIG.2

FIG.3

EP 2 583 177 B1

EP 2 583 177 B1

|  |  |  |  |  |  |  | matrice<br>tout à<br>zéro<br>7×3 |
|---|---|---|---|---|---|---|---|
| H (matrice SEC-DED)<br>7×39 | | | | | | | |
| 3×32 matrice tout à zéro | 1 | 1 | 0 | 1 | 1 | 0 | 0 | matrice<br>d'identité<br>3×3 |
| | 1 | 0 | 1 | 1 | 0 | 1 | 0 | |
| | 1 | 1 | 1 | 0 | 0 | 0 | 1 | |

401

# FIG.4

FIG.5

600

$V_0$ ... $V_{n+s-f-1}$ $V_{n+s-f}$ ... $V_{n+s-1}$

601 602 603 604

$(M_0^0, M_0^{n+s-f}...M_0^{n+s-1})$

$(M_{n+s-f-1}^{n+s-f-1},$

$M_{n+s-f-1}^{n+s}...M_{n+s-f-1}^{n+s-1})$

$(M_{n+s-f}^0...M_{n+s-f}^{n+s-f-1},$

$M_{n+s-f}^{n+s-f})$

$(M_{n+s-1}^0...M_{n+s-1}^{n+s-f-1},$

$M_{n+s-1}^{n+s-1})$

$C_0$ $C_{n+s-f-1}$ $C_{n+s-f}$ $C_{n+s-1}$

605 606

FIG.6

## RÉFÉRENCES CITÉES DANS LA DESCRIPTION

**Documents brevets cités dans la description**

- US 3755779 A
- US 20050149 A1

**Littérature non-brevet citée dans la description**

- **C. H. STAPPER ; HSING-SAN LEE.** Synergistic Fault-Tolerance for Memory Chips. *IEEE Trans. Computers,* 1992, vol. 41 (9), 1078-1087